# EUROPÄISCHE PATENTANMELDUNG

(11) **EP 2 947 669 A1**
(43) Veröffentlichungstag der Anmeldung: **25.11.2015**
(21) Anmeldenummer: 14169259.0
(22) Anmeldetag: 21.05.2014
(51) Int. Cl.: H01F 30/08, G01R 31/14, G01R 31/16

(54) **Stromkreisanordnung für eine Hochspannungsprüfanlage**

(71) Anmelder: Siemens Aktiengesellschaft, 80333 München (DE)
(72) Erfinder: Bock, Markus, 96047 Bamberg (DE)

(57) **Zusammenfassung**

Die Erfindung betrifft eine Stromkreisanordnung (100) für eine Hochspannungsprüfanlage. Die Stromkreisanordnung (100) umfasst einen ersten Stromkreis (110) mit wenigstens einer als Luftspule ausgebildeten Niederspannungsspule (13 bis 16) und einen zur Aufnahme eines Prüflings (40) ausgebildeten zweiten Stromkreis (120) mit wenigstens einer Hochspannungsspule (1 bis 3). Die wenigstens eine Niederspannungsspule (13 bis 16) und die wenigstens eine Hochspannungsspule (1 bis 3) sind zur induktiven Energieübertragung von dem ersten Stromkreis (110) in den zweiten Stromkreis (120) ausgebildet und angeordnet.

## Beschreibung

Die Erfindung betrifft eine Stromkreisanordnung für eine Hochspannungsprüfanlage.

Hochspannungsprüfanlagen werden häufig als so genannte Resonanzprüfanlagen ausgeführt, in denen die an einen Prüfling angelegte Hochspannung mittels einer Hochspannungsdrossel erzeugt wird. Ein kapazitiver Prüfling und die Hochspannungsdrossel werden dabei elektrisch in Reihe geschaltet und bilden dadurch einen Resonanzstromkreis, da sich der Prüfling im Wesentlichen wie ein Kondensator verhält. Dadurch kann aufgrund des Resonanzprinzips die für die Hochspannungsprüfung benötigte Prüfungswechselspannung mit einer deutlich (typisch um einen Faktor 20 bis 100) kleineren Anregungswechselspannung erzeugt werden, wenn die Frequenz der Anregungswechselspannung mit der Resonanzfrequenz des Resonanzstromkreises übereinstimmt. Die Hochspannungsdrossel weist dabei wenigstens eine Hochspannungsspule auf, die üblicherweise mittels eines Anregungstransformators, der auch als Exciter bezeichnet wird, mit der Anregungswechselspannung angeregt wird, wobei die Leistungseinspeisung an einem erdnahen Ende der Hochspannungsspule erfolgt.

Eine Drosselanordnung für Hochspannungsprüfanlagen wird beispielsweise in DE 10 2008 011 803 A1 offenbart. Die Drosselanordnung weist eine Spule mit Teilwicklungen auf, die sich um eine Wickelachse herum erstrecken und unterschiedliche Wickelsinne aufweisen.

Der Erfindung liegt die Aufgabe zugrunde, eine verbesserte Stromkreisanordnung für eine als Resonanzprüfanlage ausgebildete Hochspannungsprüfanlage anzugeben.

Die Aufgabe wird erfindungsgemäß durch die Merkmale des Anspruchs 1 gelöst.

Vorteilhafte Ausgestaltungen der Erfindung sind Gegenstand der Unteransprüche.

Eine erfindungsgemäße Stromkreisanordnung für eine Hochspannungsprüfanlage umfasst einen ersten Stromkreis mit wenigstens einer als Luftspule ausgebildeten Niederspannungsspule und einen zur Aufnahme eines Prüflings ausgebildeten zweiten Stromkreis mit wenigstens einer Hochspannungsspule. Dabei sind die wenigstens eine Niederspannungsspule und die wenigstens eine Hochspannungsspule zur induktiven Energieübertragung von dem ersten Stromkreis in den zweiten Stromkreis ausgebildet und angeordnet.

Die Erfindung ermöglicht dadurch, die Leistung mittels wenigstens einer Niederspannungsspule in die Hochspannungsspule oder Hochspannungsspulen durch eine magnetische Kopplung der Nieder- und Hochspannungsspulen einzuspeisen. Es wird also kein Anregungstransformator (Exciter) zur Anregung der Hochspannungsspule oder Hochspannungsspulen benötigt, wodurch auch kein Mittelspannungskabel und kein Mittelspannungsstecker zur Verbindung des Anregungstransformators und der Hochspannungsspule oder Hochspannungsspulen benötigt wird. Dadurch werden vorteilhaft die Kosten und das Gewicht der Stromkreisanordnung reduziert, wobei die Gewichtsreduktion insbesondere bei mobilen Anlagen vorteilhaft ist. Die Ausbildung der wenigstens einen Niederspannungsspule als Luftspule nutzt vorteilhaft aus, dass aufgrund des Resonanzprinzips eine verhältnismäßig geringe Anregungsspannung zur Erzeugung der Hochspannung für die Hochspannungsprüfung ausreicht.

Eine Ausgestaltung der Erfindung sieht eine Hochspannungsspule mit um wenigstens eine Niederspannungsspule herum geführten Windungen vor.

Bei dieser Ausgestaltung ist eine Niederspannungsspule also innerhalb einer Hochspannungsspule angeordnet. Diese Spulenanordnung ist besonders bauraumsparend.

Dabei ist die Hochspannungsspule mit um wenigstens eine Niederspannungsspule herum geführten Windungen vorzugsweise geerdet.

Dadurch wird vorteilhaft eine zu hohe Potentialdifferenz zwischen der Hochspannungsspule und der in ihr angeordneten Niederspannungsspule vermieden.

Eine weitere Ausgestaltung der Erfindung sieht zusätzlich oder alternativ wenigstens eine Niederspannungsspule mit um wenigstens eine Hochspannungsspule herum geführten Windungen vor.

Diese Ausgestaltung erfordert im Vergleich zu der vorgenannten Ausgestaltung zwar eine Niederspannungsspule mit einem größeren Wicklungsumfang, ermöglicht jedoch vorteilhaft eine größere magnetische Kopplung der Niederspannungsspule und der Hochspannungsspule.

Dabei kann die wenigstens eine Hochspannungsspule in einem Gehäuse angeordnet sein und die wenigstens eine Niederspannungsspule mit um wenigstens eine Hochspannungsspule herum geführten Windungen außerhalb des Gehäuses angeordnet sein.

Bei dieser Spulenanordnung sind die Potentialunterschiede zwischen der Hochspannungsspule und der Niederspannungsspule weniger kritisch, insbesondere wenn das Gehäuse mit einem isolierenden Medium gefüllt wird, so dass diese Spulenanordnung vorteilhaft ermöglicht, mehrere Hochspannungsspulen in dieser Weise an Niederspannungsspulen zu koppeln.

Dabei ist das Gehäuse vorzugsweise als ein Hohlisolator ausgebildet.

Gegenüber herkömmlichen metallischen Gehäusen vermeidet ein als Hohlisolator ausgebildetes Gehäuse vorteilhaft das Auftreten von Wirbelstromverlusten in der Gehäusewand. Das Gehäuse ist vorzugsweise aus glasfaserverstärktem Kunststoff gefertigt.

Alternativ oder zusätzlich kann eine Niederspannungsspule mit um eine Hochspannungsspule herum geführten Windungen innerhalb des Gehäuses angeordnet werden. Dabei ist die Hochspannungsspule, um die herum Windungen einer in dem Gehäuse angeordneten Niederspannungsspule geführt sind, vorzugsweise geerdet.

Auch bei dieser Spulenanordnung wird durch die Erdung der Hochspannungsspule vorteilhaft eine zu hohe Potentialdifferenz zwischen der Hochspannungsspule und der Niederspannungsspule vermieden.

Eine weitere Ausgestaltung der Erfindung sieht vor, dass die Windungen der wenigstens einen Niederspannungsspule und der wenigstens einen Hochspannungsspule um eine gemeinsame Wickelachse herum geführt sind.

Dies ermöglicht vorteilhaft eine gute magnetische Kopplung der Nieder- und Hochspannungsspulen.

Eine weitere Ausgestaltung der Erfindung sieht vor, dass der erste Stromkreis als ein Resonanzstromkreis ausgebildet ist.

Die Ausbildung auch des ersten Stromkreises als Resonanzstromkreis ermöglicht vorteilhaft eine noch effektivere Einspeisung von Energie in den zweiten Stromkreis.

Eine weitere Ausgestaltung der Erfindung sieht vor, dass der erste Stromkreis eine Stromrichtereinheit zur Erzeugung einer Anregungswechselspannung mit einer einstellbaren Grundfrequenz aufweist.

Dadurch kann die Frequenz der Anregungswechselspannung auf die Resonanzfrequenz des zweiten Stromkreises eingestellt werden. Das ist vorteilhaft, da die Resonanzfrequenz von der Kapazität des Prüflings abhängt.

Eine erfindungsgemäße Hochspannungsprüfungsanlage weist eine erfindungsgemäße Stromkreisanordnung mit den bereits genannten Vorteilen auf.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: schematisch eine Stromkreisanordnung für eine Hochspannungsprüfanlage,
- FIG 2: ein erstes Ausführungsbeispiel einer Spulenanordnung in einer Schnittdarstellung,
- FIG 3: ein zweites Ausführungsbeispiel einer Spulenanordnung in einer Schnittdarstellung, und
- FIG 4: ein drittes Ausführungsbeispiel einer Spulenanordnung in einer Schnittdarstellung.

Einander entsprechende Teile sind in allen Figuren mit den gleichen Bezugszeichen versehen.

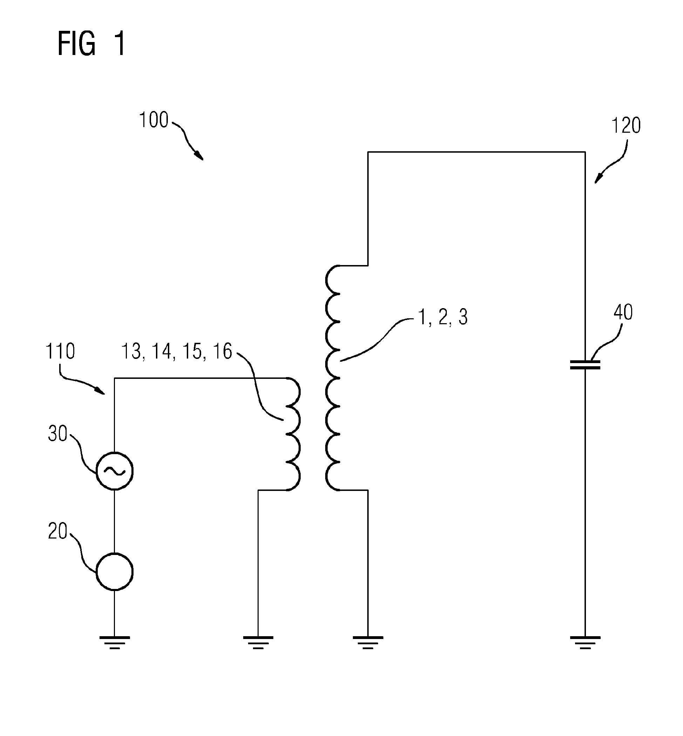

Figur 1 zeigt schematisch eine Stromkreisanordnung 100 für eine Hochspannungsprüfungsanlage. Die Stromkreisanordnung 100 weist einen ersten Stromkreis 110 mit einer Spannungsquelle 20, einer Stromrichtereinheit 30 und wenigstens einer als Luftspule ausgebildeten Niederspannungsspule 13 bis 16 auf. Ferner weist die Stromkreisanordnung 100 einen zur Aufnahme eines Prüflings 40 ausgebildeten zweiten Stromkreis 120 mit wenigstens einer Hochspannungsspule 1 bis 3 auf. Der Prüfling 40 ist dabei in Figur 1 als Kondensator dargestellt, da er sich bei der Hochspannungsprüfung in der Regel wie ein Kondensator verhält.

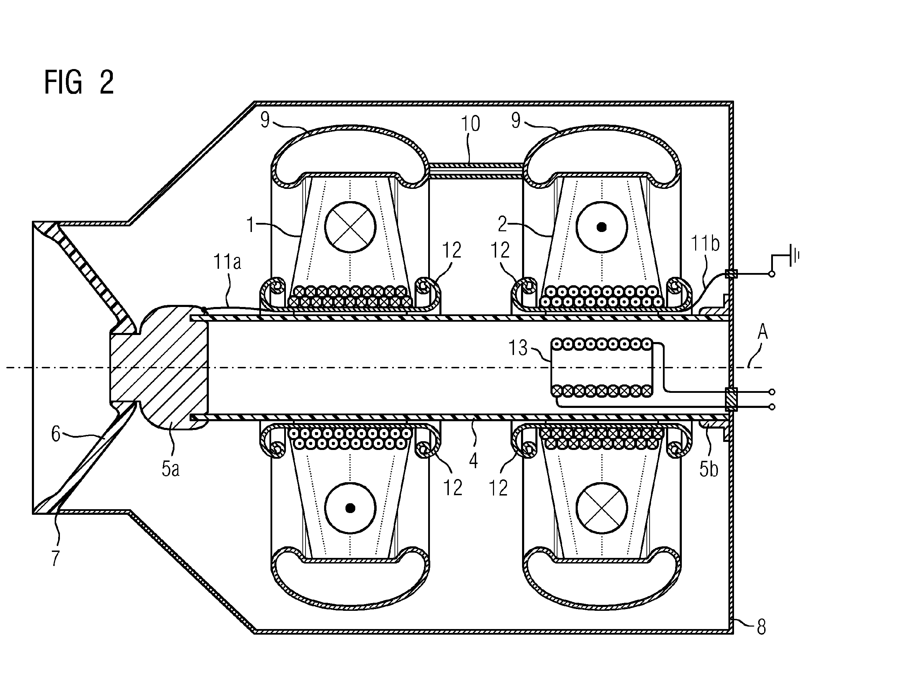

Die Stromrichtereinheit 30 ist zur Erzeugung einer Anregungswechselspannung mit einer einstellbaren Grundfrequenz aus einer von der Spannungsquelle 20 gelieferten Versorgungsspannung ausgebildet. Die wenigstens eine Niederspannungsspule 13 bis 16 und die wenigstens eine Hochspannungsspule 1 bis 3 sind zur induktiven Energieübertragung von dem ersten Stromkreis 110 in den zweiten Stromkreis 120 ausgebildet und angeordnet. Ausführungsbeispiele dafür geeigneter Spulenanordnungen werden unten anhand der Figuren 2 bis 4 beschrieben.

Der zweite Stromkreis 120 mit einem Prüfling 40 ist ein Resonanzstromkreis, dessen Resonanzfrequenz von der Induktivität der wenigstens einen Hochspannungsspule 1 bis 3 und der Kapazität des Prüflings 40 abhängt. Bei einer Hochspannungsprüfung wird die Grundfrequenz der Anregungswechselspannung mittels der Stromrichtereinheit 30 auf die Resonanzfrequenz des zweiten Stromkreises 120 eingestellt.

Figur 2 zeigt ein erstes Ausführungsbeispiel einer Spulenanordnung in einer Schnittdarstellung. Die Spulenanordnung weist eine erste Hochspannungsspule 1 und eine zweite Hochspannungsspule 2 auf. Die Hochspannungsspulen 1, 2 weisen jeweils eine Vielzahl von Windungen auf, welche um eine gemeinsame Wickelachse A herum verlaufen, und sind als Luftspulen ausgebildet. Koaxial zu der Wickelachse A ist ein Tragelement 4 angeordnet. Das Tragelement 4 ist als elektrisch isolierendes Rohr ausgestaltet. Als Material zur Ausbildung des Tragelementes 4 sind beispielsweise keramische Werkstoffe, Harze, Faserverbundwerkstoffe, wie beispielsweise glasfaserverstärktes Harz einsetzbar. Das Tragelement 4 ist an seinen axialen Enden jeweils in einer ersten Einspannung 5a sowie einer zweiten Einspannung 5b festgelegt. Die erste Einspannung 5a ist als elektrischer Leiterzug ausgestaltet, welcher eine rotationssymmetrische Struktur aufweist, wobei die Rotationsachse der ersten Einspannung 5a koaxial zur Wickelachse A ausgerichtet ist. Die erste Einspannung 5a weist eine ringförmig umlaufende Nut auf, in welche das Tragelement 4 eingeschoben ist. Die zweite Einspannung 5b ist als Flanschsockel ausgeführt, welcher ein Ende des Tragelementes umgreift. Die erste Einspannung 5a ist fluiddicht in einen Isolator 6, beispielsweise einen Schotisolator, einen Scheibenisolator oder eine Hochspannungsdurchführung eingesetzt.

Der Isolator 6 ist an einem Flansch 7 fluiddicht mit einem Gehäuse 8 verbunden. Das Gehäuse 8 ist als ein Hohlisolator ausgebildet und vorzugsweise aus glasfaserverstärktem Kunststoff gefertigt. Das Gehäuse 8 ist dabei rotationssymmetrisch ausgestaltet und zu der Wickelachse A koaxial ausgerichtet. Der von dem Flansch 7 abgewandte Bereich des Gehäuses 8 ist von dem Gehäuse 8 scheibenförmig verschlossen. Der scheibenförmige Boden des Gehäuses 8 dient der Halterung der zweiten Einspannung 5b. Das Gehäuse 8 ist fluiddicht ausgeführt. Durch ein fluiddichtes Verschließen des Flansches 7 ist das Innere des Gehäuses 8 vor einem Eindringen bzw. Austreten von Stoffen durch die von dem Gehäuse 8 und weitere Baugruppen gebildete Kapselung geschützt. Dadurch ist es möglich, das Innere des Gehäuses 8 mit einem Fluid zu befüllen. Das Fluid ist beispielsweise ein Isoliergas, welches mit einem erhöhten Druck beaufschlagt ist. So ist es beispielsweise möglich, das Innere mit Schwefelhexafluorid zu befüllen und unter einen erhöhten Druck zu setzen, um die Isolationsfestigkeit des Isoliergases zusätzlich zu erhöhen.

In dem Gehäuses 8 sind die Hochspannungsspulen 1, 2 angeordnet. Die Hochspannungsspulen 1, 2 sind einander ähnlich aufgebaut. Sie weisen jeweils eine im Wesentlichen hohlzylindrische äußere Gestalt auf, wobei die stirnseitigen Abschnitte der jeweiligen Hohlzylinder mit kegelartigen Anformungen versehen sind, so dass die Hochspannungsspulen 1, 2 jeweils eine diskusartige Struktur bilden. An den äußeren Umfängen der Hochspannungsspulen 1, 2 ist jeweils ein erster Schirmkörper 9 angeordnet. Die ersten Schirmkörper 9 weisen eine ringförmige Struktur auf, welche koaxial zur Wickelachse A umlaufend ausgebildet ist. Die ersten Schirmkörper 9 weisen jeweils einen elektrisch isolierenden Tragkörper auf, welcher auf die jeweilige Hochspannungsspule 1, 2 aufgesetzt und mit dieser verspannt ist. Dadurch ist es möglich, dass die ersten Schirmkörper 9 jeweils auch eine mechanische Stabilisierung der Hochspannungsspulen 1, 2 bewirken.

Die hohlzylindrische Gestalt der ersten und der zweiten Hochspannungsspule 1, 2 ist durch ein Wickeln eines elektrisch leitenden Leiters um die Wickelachse A herum bestimmt. Dabei wird der Leiter in einer Vielzahl von Lagen schraubenförmig um die Wickelachse A herum gewunden, wobei die Lagen spiralförmig übereinanderliegend um die Wickelachse A herum angeordnet werden. Dadurch werden jeweils eine Vielzahl von Windungen in der ersten und der zweiten Hochspannungsspule 1, 2 gebildet. Von der äußeren Erscheinung her sind die beiden Hochspannungsspulen 1,2 gleichartig ausgestaltet. Lediglich der Wickelsinn der Windungen der ersten und der zweiten Hochspannungsspule 1, 2 um die Wickelachse A herum ist jeweils unterschiedlich ausgebildet. Der unterschiedliche Wickelsinn ist in Figur 2 durch die punkt- und kreuzförmigen Symbole in den jeweiligen Hälften bezüglich der Wickelachse A symbolisch dargestellt. Des Weiteren sind jeweils die ersten Windungen der Hochspannungsspulen 1, 2, welche sich in unmittelbarer Nähe des Tragelements 4 erstrecken, dargestellt. Die weiteren durch eine Punktierung symbolisierten Lagen von Windungen wurden aus Übersichtlichkeitsgründen nicht dargestellt. Stattdessen wurde ein Kreuz- und ein Punktsymbol zur Symbolisierung des Verlaufes der Windungsrichtungen dargestellt.

Zwischen den Hochspannungsspulen 1, 2 ist eine Brücke 10 angeordnet. Die Brücke 10 ist im Wesentlichen durch einen rohrförmigen Schirmkörper gebildet, welcher eine mechanische Stabilität der Brücke 10 gewährleistet. Im Innern des rohrförmigen Schirmkörpers ist ein elektrischer Leiter geführt, welcher an der ersten und der zweiten Hochspannungsspule 1, 2 am äußeren Umfang befindliche erste Leiterenden miteinander kontaktiert. Die jeweils am entgegengesetzten Ende der ersten und der zweiten Hochspannungsspule 1, 2 liegenden zweiten Leiterenden 11a, 11b sind jeweils im Bereich des Tragelementes 4 geführt und dort mit den entsprechenden Anschlusspunkten elektrisch leitend verbunden.

Das zweite Leiterende 11a der ersten Hochspannungsspule 1 ist mit der ersten Einspannung 5a elektrisch leitfähig verbunden. Die erste Einspannung 5a ist fluiddicht durch den Isolator 6 hindurchgeführt, so dass außerhalb des Gehäuses 8 eine elektrische Kontaktierung der ersten Einspannung 5a und somit der Hochspannungsspulen 1, 2 erfolgen kann. Das zweite Leiterende 11b der zweiten Hochspannungsspule 2 ist fluiddicht durch das Gehäuse 8 hindurchgeführt und geerdet.

Zwischen den inneren Windungen jeder Hochspannungsspule 1, 2 und der Außenoberfläche des Tragelementes 4 ist zur dielektrischen Abschirmung jeweils ein zweiter Schirmkörper 12 angeordnet. Die zweiten Schirmkörper 12 sind jeweils im Wesentlichen hohlzylinderartig geformt und in ihren Endbereichen jeweils trichterartig erweitert und mit aufgewickelten Enden ausgeführt.

In dem Inneren des Tragelementes 4 ist im Bereich der zweiten Hochspannungsspule 2 eine Niederspannungsspule 13 angeordnet, so dass die Windungen der zweiten Hochspannungsspule 2 um die Niederspannungsspule 13 herum geführt sind. Die Leiterenden der Niederspannungsspule 13 sind aus dem Gehäuse 8 herausgeführt. Die Windungen der Niederspannungsspule 13 sind um die Wickelachse A herum geführt.

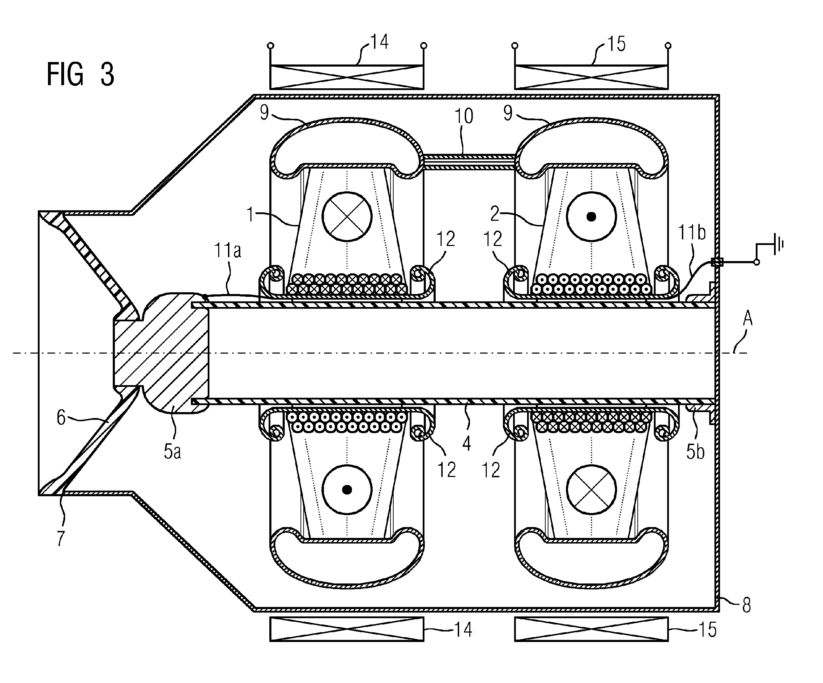

Figur 3 zeigt ein zweites Ausführungsbeispiel einer Spulenanordnung in einer Schnittdarstellung. Diese Spulenanordnung unterscheidet sich von dem in Figur 2 dargestellten Ausführungsbeispiel lediglich dadurch, dass sie statt einer im Inneren des Tragelementes 4 angeordneten Niederspannungsspule 13 zwei Niederspannungsspulen 14, 15 aufweist, die außerhalb des Gehäuses 8 angeordnet sind. Dabei verläuft eine erste Niederspannungsspule 14 an der Außenoberfläche des Gehäuses 8 ringförmig um die erste Hochspannungsspule 1 herum und die zweite Niederspannungsspule 15 verläuft an der Außenoberfläche des Gehäuses 8 ringförmig um die zweite Hochspannungsspule 2 herum, wobei die (in Figur 3 nicht dargestellten) Windungen der Niederspannungsspulen 14, 15 um die jeweilige Hochspannungsspule 1, 2 und die Wickelachse A herum geführt sind.

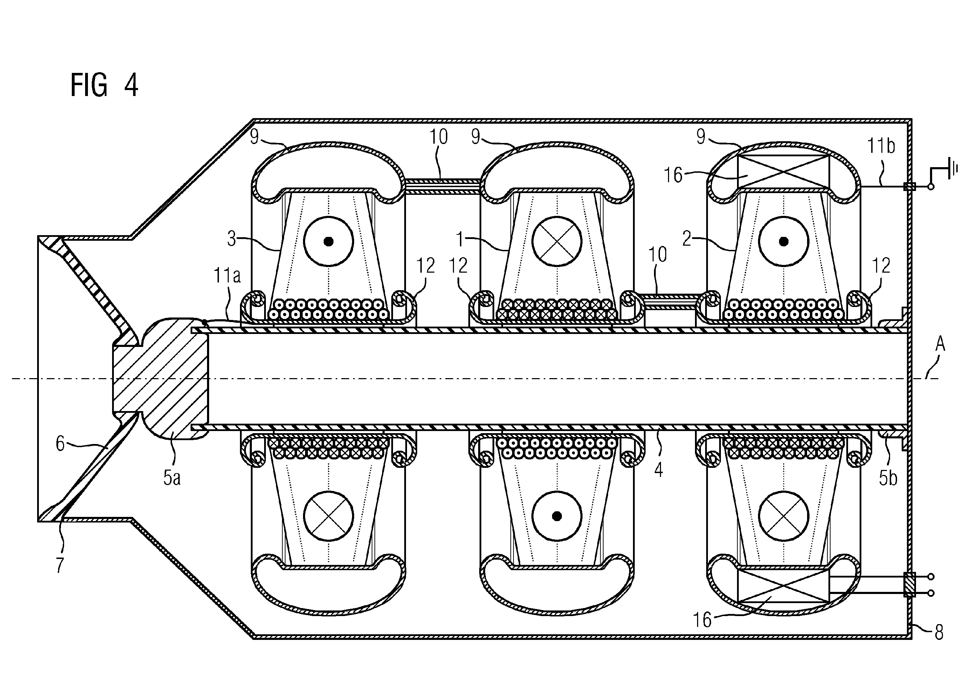

Figur 4 zeigt ein drittes Ausführungsbeispiel einer Spulenanordnung in einer Schnittdarstellung. Diese Spulenanordnung weist im Unterschied zu den in den Figuren 2 und 3 dargestellten Ausführungsbeispielen drei Hochspannungsspulen 1, 2, 3 auf. Ferner weist sie statt einer im Inneren des Tragelementes 4 angeordneten Niederspannungsspule 13 oder zweier außerhalb des Gehäuses 8 angeordneter Niederspannungsspulen 14, 15 eine Niederspannungsspule 16 auf, die innerhalb eines ersten Schirmkörpers 9 angeordnet ist, der um eine über ein zweites Leiterende 11b geerdete zweite Hochspannungsspule 2 herum angeordnet ist. Abgesehen davon ist die Spulenanordnung dieses Ausführungsbeispiels analog zu den in den Figuren 2 und 3 dargestellten Ausführungsbeispielen ausgebildet. Insbesondere sind die Hochspannungsspulen 1, 2, 3 jeweils wie die Hochspannungsspulen 1, 2 der in den Figuren 2 und 3 dargestellten Ausführungsbeispiele ausgebildet und miteinander über Brücken 10 elektrisch verbunden. Die Niederspannungsspule 16 verläuft ringförmig um die zweite Hochspannungsspule 2 herum, wobei die (in Figur 4 nicht dargestellten) Windungen der Niederspannungsspule 16 um die zweite Hochspannungsspule 2 und die Wickelachse A herum geführt sind.

Die Hochspannungsspulen 1, 2, 3 sind dabei derart elektrisch in Reihe geschaltet, dass das Erdpotential an eine der außen liegenden Windungen der zweiten Hochspannungsspule 2 angelegt wird und das Potential in der zweiten Hochspannungsspule 2 von außen nach innen, in der der zweiten Hochspannungsspule 2 nachgeschalteten ersten Hochspannungsspule 1 von innen nach außen und in der der ersten Hochspannungsspule 1 nachgeschalteten dritten Hochspannungsspule 3 von außen nach innen zunimmt.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Stromkreisanordnung (100) für eine Hochspannungsprüfanlage, umfassend
- einen ersten Stromkreis (110) mit wenigstens einer als Luftspule ausgebildeten Niederspannungsspule (13 bis 16)
- und einen zur Aufnahme eines Prüflings (40) ausgebildeten zweiten Stromkreis (120) mit wenigstens einer Hochspannungsspule (1 bis 3),
- wobei die wenigstens eine Niederspannungsspule (13 bis 16) und die wenigstens eine Hochspannungsspule (1 bis 3) zur induktiven Energieübertragung von dem ersten Stromkreis (110) in den zweiten Stromkreis (120) ausgebildet und angeordnet sind.

2. Stromkreisanordnung (100) nach Anspruch 1,
**gekennzeichnet durch** eine Hochspannungsspule (1 bis 3) mit um wenigstens eine Niederspannungsspule (13 bis 16) herum geführten Windungen.

3. Stromkreisanordnung (100) nach Anspruch 2,
**dadurch gekennzeichnet, dass** die Hochspannungsspule (1 bis 3) mit um wenigstens eine Niederspannungsspule (13 bis 16) herum geführten Windungen geerdet ist.

4. Stromkreisanordnung (100) nach einem der vorhergehenden Ansprüche,
**gekennzeichnet durch** wenigstens eine Niederspannungsspule (13 bis 16) mit um wenigstens eine Hochspannungsspule (1 bis 3) herum geführten Windungen.

5. Stromkreisanordnung (100) nach Anspruch 4,
**dadurch gekennzeichnet, dass** die wenigstens eine Hochspannungsspule (1 bis 3) in einem Gehäuse (8) angeordnet ist und wenigstens eine Niederspannungsspule (13 bis 16) mit um wenigstens eine Hochspannungsspule (1 bis 3) herum geführten Windungen außerhalb des Gehäuses (8) angeordnet ist.

6. Stromkreisanordnung (100) nach Anspruch 5,
**gekennzeichnet durch** ein als ein Hohlisolator ausgebildetes Gehäuse (8).

7. Stromkreisanordnung (100) nach einem der Ansprüche 4 bis 6,
**dadurch gekennzeichnet, dass** die wenigstens eine Hochspannungsspule (1 bis 3) in einem Gehäuse (8) angeordnet ist und eine Niederspannungsspule (13 bis 16) mit um eine Hochspannungsspule (1 bis 3) herum geführten Windungen innerhalb des Gehäuses (8) angeordnet ist.

8. Stromkreisanordnung (100) nach Anspruch 7,
**dadurch gekennzeichnet, dass** die Hochspannungsspule (1 bis 3), um die herum Windungen einer in dem Gehäuse (8) angeordneten Niederspannungsspule (13 bis 16) geführt sind, geerdet ist.

9. Stromkreisanordnung (100) nach einem der vorhergehenden Ansprüche,
**dadurch gekennzeichnet, dass** die Windungen der wenigstens einen Niederspannungsspule (13 bis 16) und der wenigstens einen Hochspannungsspule (1 bis 3) um eine gemeinsame Wickelachse (A) herum geführt sind.

10. Stromkreisanordnung (100) nach einem der vorhergehenden Ansprüche,
**dadurch gekennzeichnet, dass** der erste Stromkreis (110) als ein Resonanzstromkreis ausgebildet ist.

11. Stromkreisanordnung (100) nach einem der vorhergehenden Ansprüche,
**dadurch gekennzeichnet, dass** der erste Stromkreis (110) eine Stromrichtereinheit (30) zur Erzeugung einer Anregungswechselspannung mit einer einstellbaren Grundfrequenz aufweist.

12. Hochspannungsprüfungsanlage mit einer Stromkreisanordnung (100) nach einem der vorhergehenden Ansprüche.
